# EUROPEAN PATENT APPLICATION

(11) **EP 4 379 790 A1**
(43) Date of publication of application: **05.06.2024**
(21) Application number: 22848872.2
(22) Date of filing: 24.02.2022
(51) Int. Cl.: H01L 23/12, H01L 21/60

(54) **SEMICONDUCTOR DEVICE AND ELECTRONIC DEVICE**

(30) Priority: 30.07.2021 JP 2021125616
(71) Applicant: Sony Semiconductor Solutions Corporation, Atsugi-shi, Kanagawa 243-0014 (JP)
(72) Inventor: NISHIDA, Yuji, Atsugi-shi, Kanagawa 243-0014 (JP); YOKOYAMA, Kazutoshi, Kikuchi-gun, Kumamoto 869-1102 (JP)
(74) Representative: MFG Patentanwälte Meyer-Wildhagen Meggle-Freund Gerhard PartG mbB
(86) International application number: PCT/JP2022/007442
(87) International publication number: WO 2023/007788

(57) **Abstract**

To improve the mounting reliability of a semiconductor device. The semiconductor device includes: a package body including a semiconductor chip and having a plurality of electrode pads arranged on one surface; and a plurality of bump electrodes that are individually bonded to the plurality of electrode pads, respectively. The plurality of bump electrodes include core bump electrodes including cores and coreless bump electrodes without cores.

## Description

### [Technical Field]

The present technology (technology according to the present disclosure) relates to a semiconductor device and an electronic device, and in particular, relates to a technology effective for application to a semiconductor device having a bump electrode and an electronic device using the semiconductor device.

### [Background Art]

In a semiconductor device in which a semiconductor chip is packaged in a package body, more and more external terminals are needed to achieve higher performance. For this reason, a semiconductor device called BGA (Ball Grid Array) type in which a plurality of ball-shaped solder bumps are arranged as external terminals on one surface of the package body has been commercialized. For example, PTL 1 discloses a semiconductor device that uses, as a solder bump, a core solder bump containing a core in a solder layer.

### [Citation List]

### [Patent Literature]

[PTL 1]
JP 2009-70699A

### [Summary]

### [Technical Problem]

Incidentally, in the manufacturing process of an electronic device, a BGA-type semiconductor device is mounted on a mounting substrate together with a discrete component (stand-alone component) such as a resistor or a capacitor. In this mounting step, the BGA semiconductor device is mounted on the mounting substrate by applying heat treatment (reflow) to melt the solder bump, which adds stress to the solder bump due to the difference in thermal expansion coefficient between the package body and the mounting substrate during the cooling process after the heat treatment. As to a core solder bump, the presence of the core an disperse the stress added due to the difference in thermal expansion coefficient between the package body and the mounting substrate, and reduce the stress concentrated at a bonding interface with a land (land on the package body side or mounting substrate side).

However, the mounting substrate is not always flat, and there are cases where the mounting substrate is warped. In such cases, the core of the core solder bump suppresses the deformation of the external shape of the solder layer, resulting in low followability to the warping of the mounting substrate, which may cause a decrease in the mounting reliability of the BGA-type semiconductor device.

In particular, when the mounting substrate is warped in the direction where the mounting surface side of the mounting substrate is convex, and when the package body is supported by the mounting substrate via the core of the core solder bump located in a part other than the outer periphery on the mounting surface side of the package body, the warpage of the mounting substrate causes the solder layer of the core solder bump located in the outer periphery on the mounting surface side of the package body to stretch in the vertical direction, causing the external shape of the core solder bump to become less cylindrical, and the bonding strength between the core solder bump and the land may decrease. This decrease in bonding strength means a decrease in mounting reliability.

An object of the present technology is to provide a technology that can improve the mounting reliability of a semiconductor device.

### [Solution to Problem]

(1) A semiconductor device according to one aspect of the present technology includes:
   a package body including a semiconductor chip and having a plurality of first lands arranged on one surface; and
   a plurality of solder bumps that are individually bonded to the plurality of lands, respectively.

   The plurality of solder bumps include core solder bumps including cores and coreless solder bumps without cores.
(2) An electronic device according to another aspect of the present technology includes:
   a semiconductor device having a plurality of first lands arranged on one surface of a package body including a semiconductor chip; a mounting substrate having a plurality of second lands arranged on one surface; and
   a plurality of solder bumps that are individually interposed between the plurality of first lands and the plurality of second lands, respectively, and are individually bonded to the plurality of first lands and the plurality of second lands, respectively.

The plurality of solder bumps include core solder bumps including cores and coreless solder bumps without cores.

### [Brief Description of Drawings]

[Fig. 1]

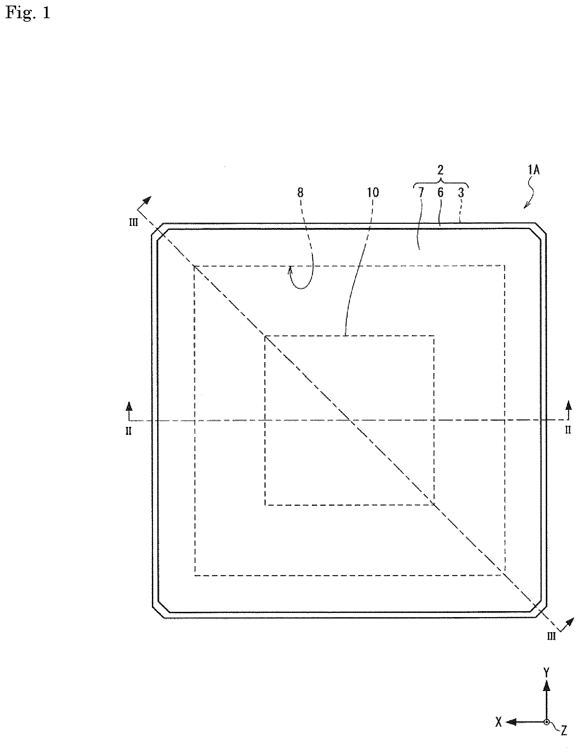

   Fig. 1 is a plan view schematically showing a configuration example of a semiconductor device according to a first embodiment of the present technology.
[Fig. 2]

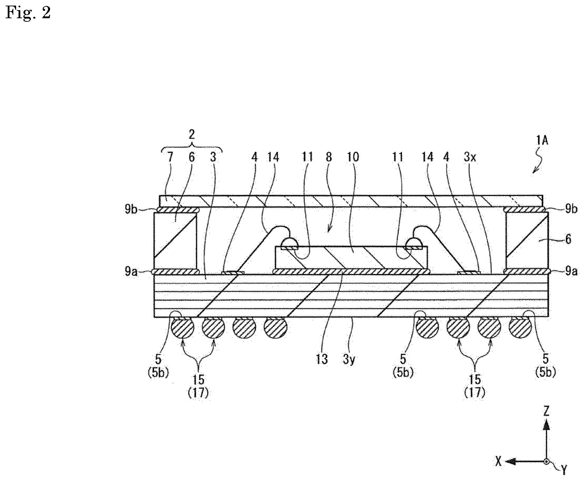

   Fig. 2 is a cross-sectional view schematically showing a cross-sectional structure taken along line II-II of Fig. 1.
[Fig. 3]

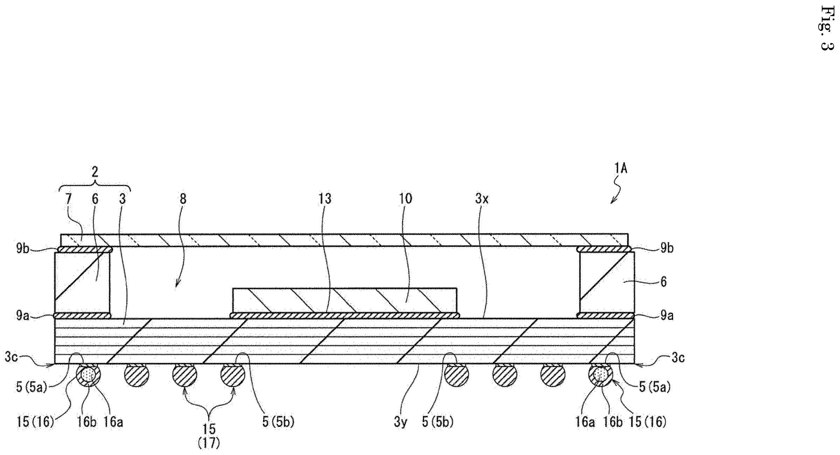

   Fig. 3 is a cross-sectional view schematically showing a cross-sectional structure taken along line III-III of Fig. 1.
[Fig. 4]

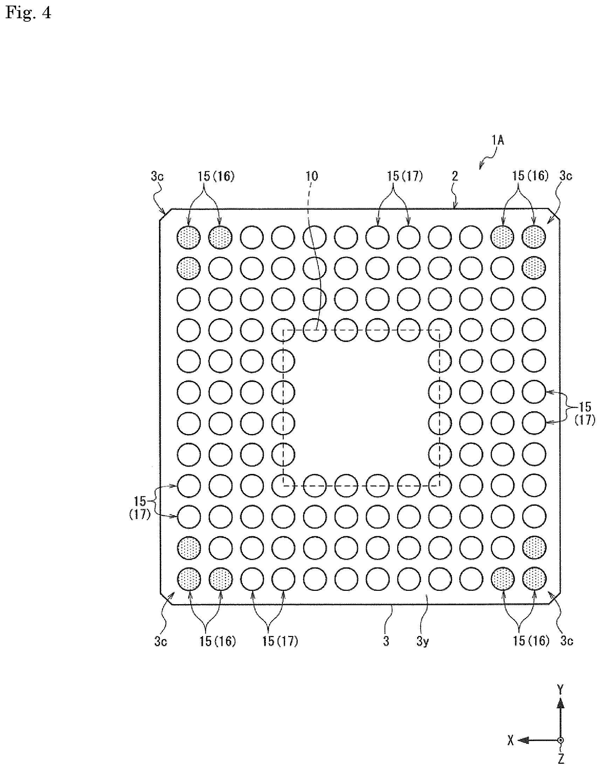

   Fig. 4 is a bottom view schematically showing a configuration example of the semiconductor device according to the first embodiment of the present technology.
[Fig. 5A]

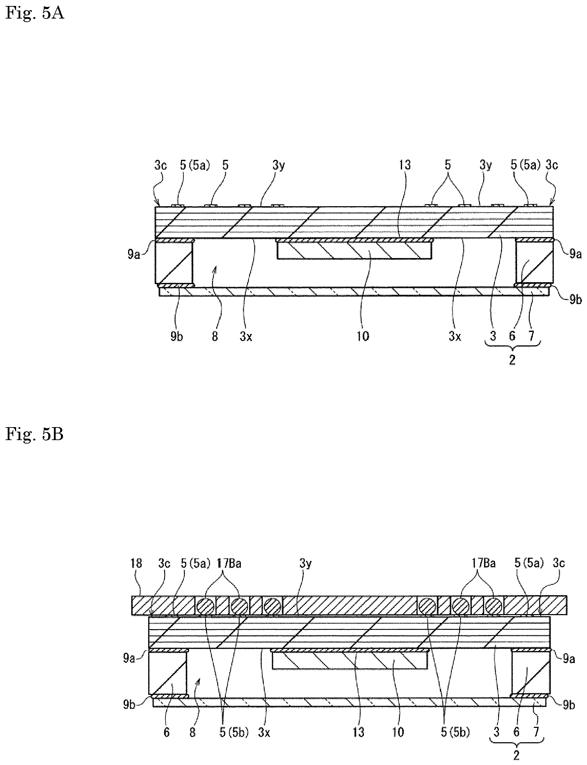

   Fig. 5A is a step cross-sectional view schematically showing a method of manufacturing the semiconductor device according to the first embodiment of the present technology.
[Fig. 5B]
   Fig. 5B is a step cross-sectional view schematically showing a step continuing from Fig. 5A.
[Fig. 5C]

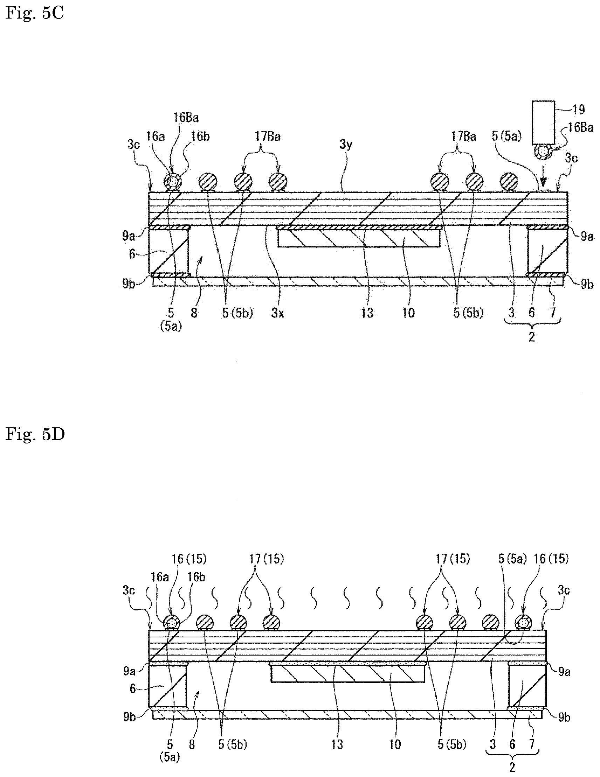

   Fig. 5C is a step cross-sectional view schematically showing a step continuing from Fig. 5B.
[Fig. 5D]
   Fig. 5D is a step cross-sectional view schematically showing a step continuing from Fig. 5C.
[Fig. 6]

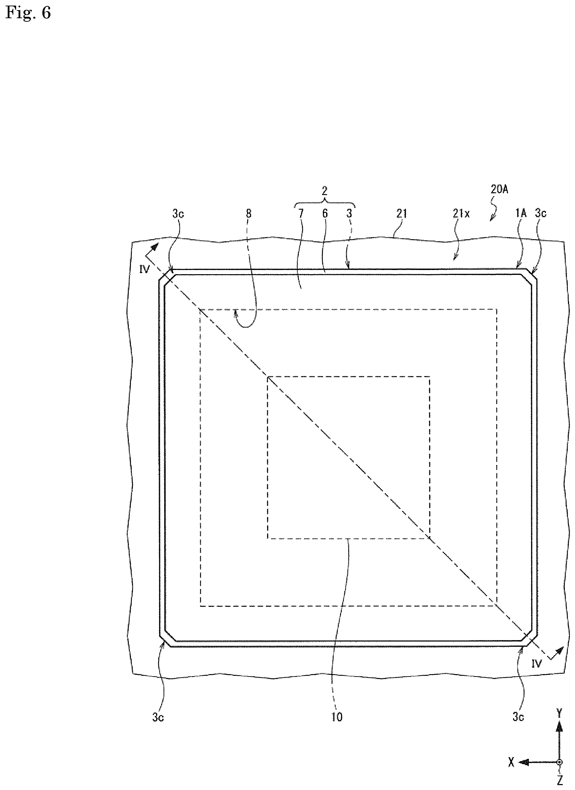

   Fig. 6 is a plan view schematically showing a configuration example of an electronic device according to the first embodiment of the present technology.
[Fig. 7]

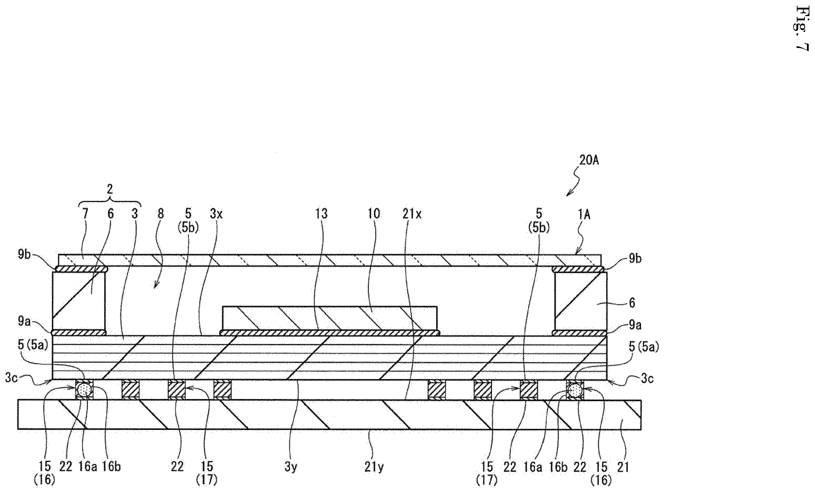

   Fig. 7 is a cross-sectional view schematically showing a cross-sectional structure taken along line IV-IV of Fig. 6.
[Fig. 8A]

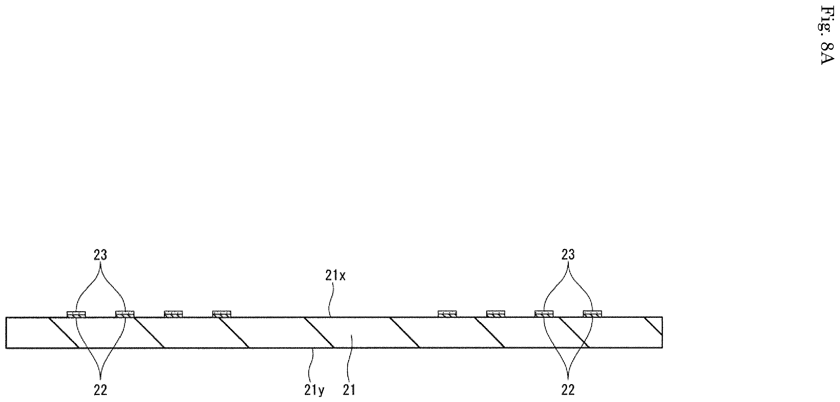

   Fig. 8A is a process cross-sectional view schematically showing a method of mounting the semiconductor device, the method being included in a method of manufacturing an electronic device according to the first embodiment of the present technology.
[Fig. 8B]

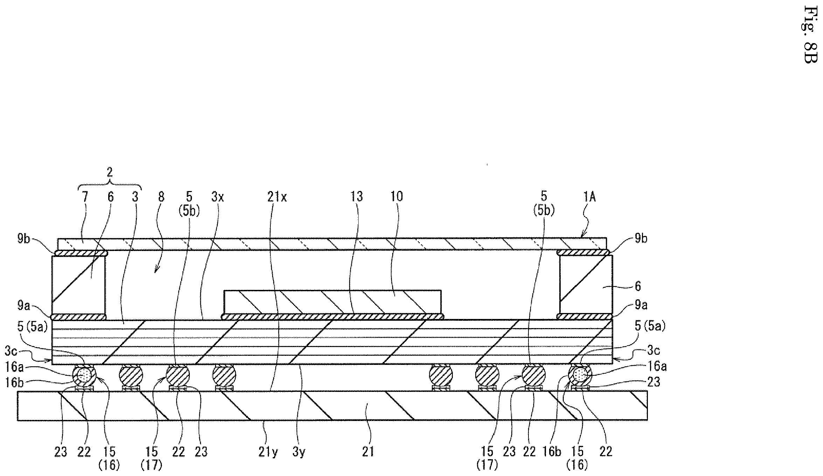

   Fig. 8B is a step cross-sectional view schematically showing a step continuing from Fig. 8A.
[Fig. 8C]

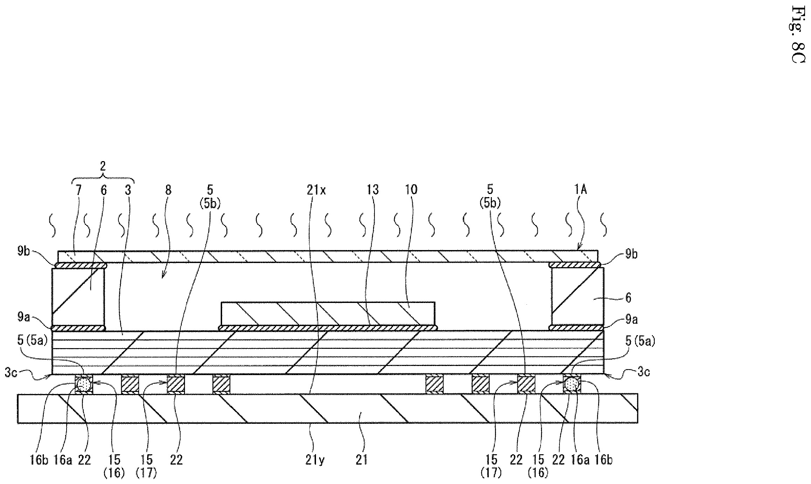

   Fig. 8C is a step cross-sectional view schematically showing a step continuing from Fig. 8B.
[Fig. 9]

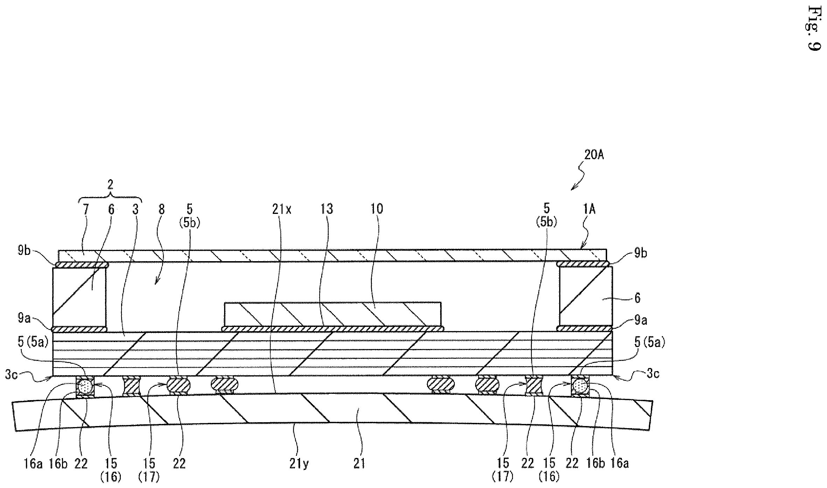

   Fig. 9 is a cross-sectional view schematically showing a state in which a mounting substrate is warped in the electronic device according to the first embodiment of the present technology.
[Fig. 10A]

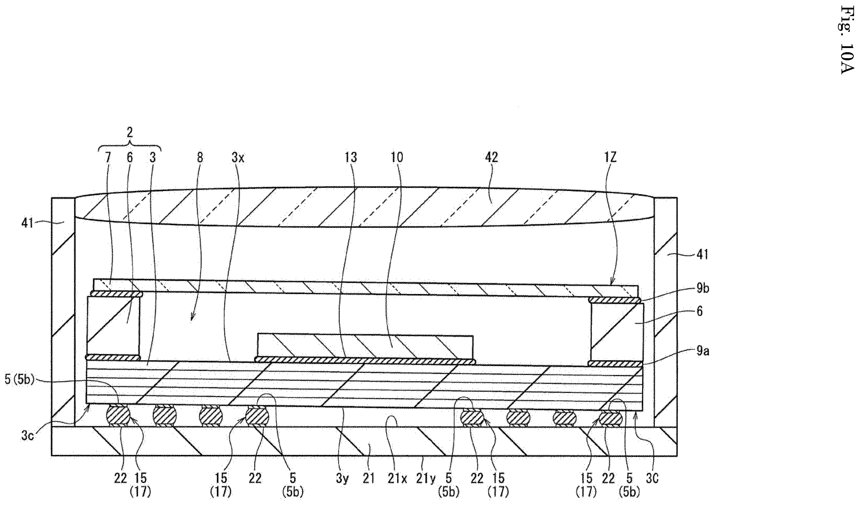

   Fig. 10A is a schematic cross-sectional view for explaining the problems of the prior art.
[Fig. 10B]

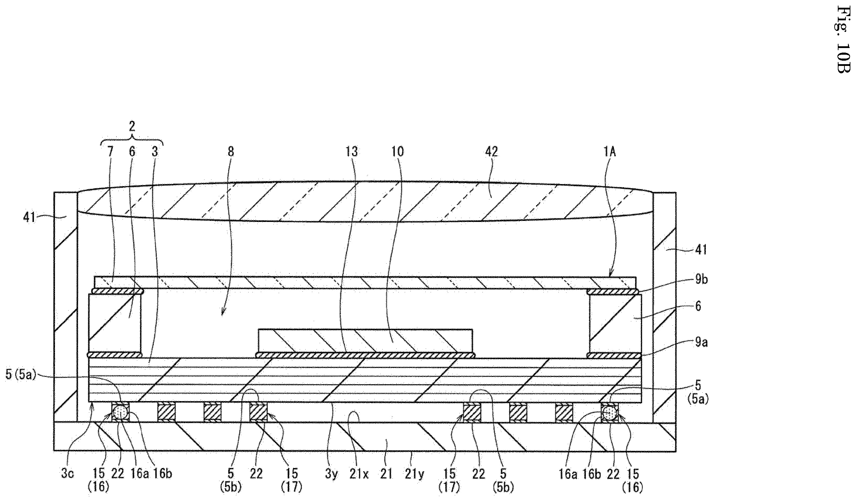

   Fig. 10B is a schematic cross-sectional view for explaining the effects of the prior art.
[Fig. 11]

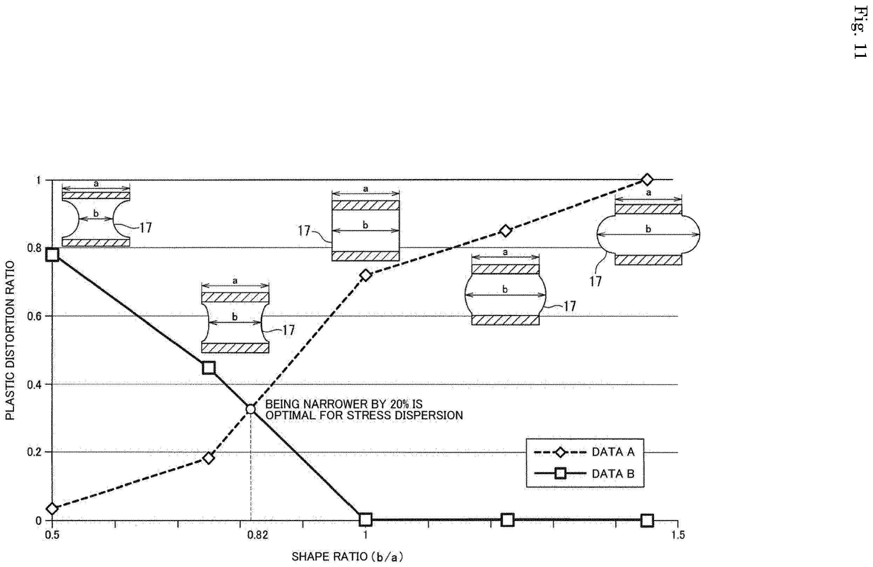

   Fig. 11 is a diagram showing a relation between an external shape and warpage of a coreless solder bump.
[Fig. 12]

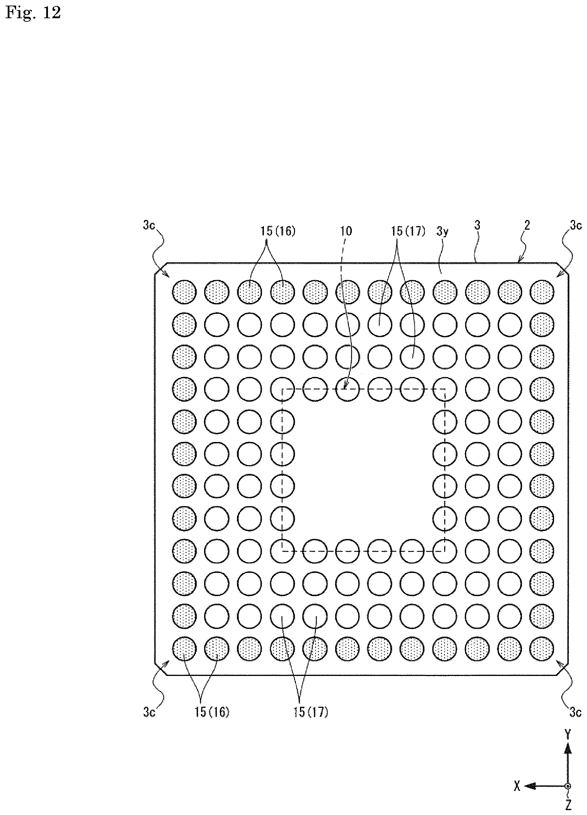

   Fig. 12 is a bottom view schematically showing a modification of the semiconductor device according to the first embodiment of the present technology.
[Fig. 13]

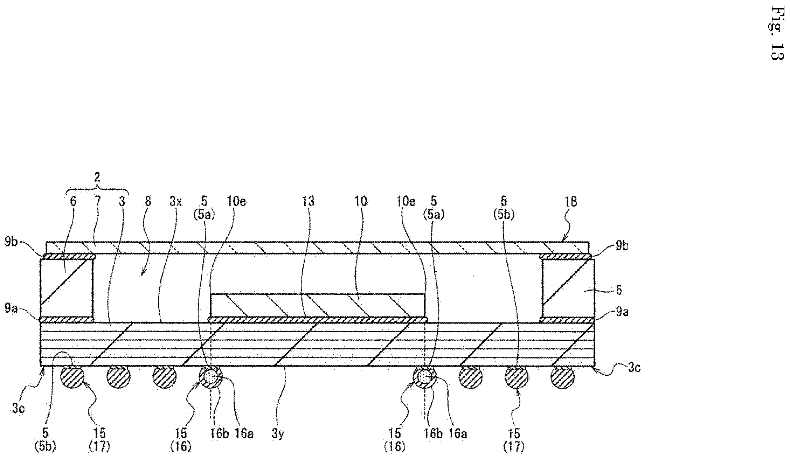

   Fig. 13 is a cross-sectional view schematically showing a configuration example of a semiconductor device according to a second embodiment of the present technology.
[Fig. 14]

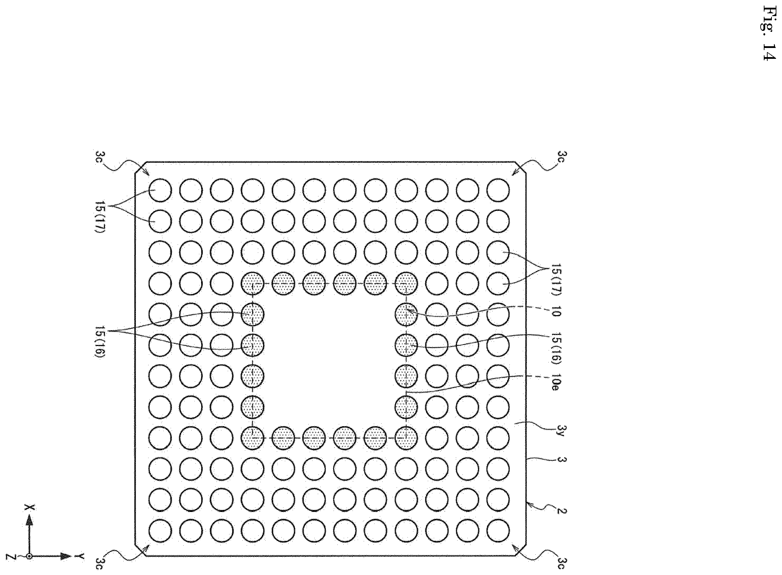

   Fig. 14 is a bottom view schematically showing a configuration example of the semiconductor device according to the second embodiment of the present technology.
[Fig. 15]

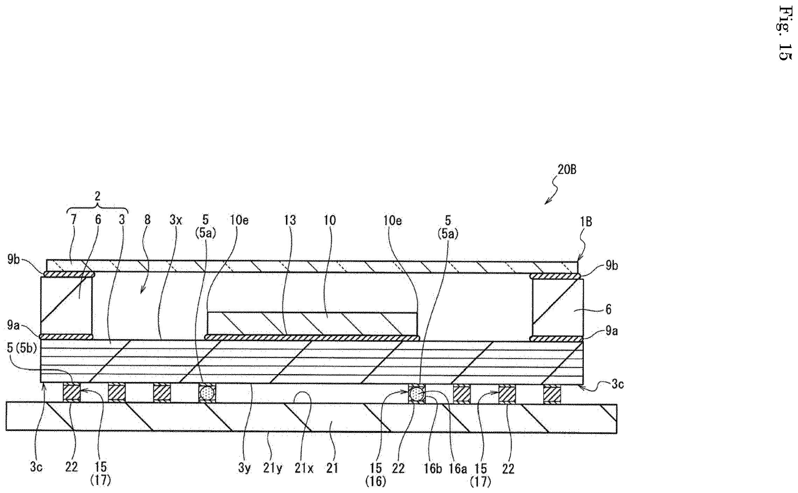

   Fig. 15 is a cross-sectional view schematically showing a configuration example of an electronic device according to the second embodiment of the present technology.
[Fig. 16]

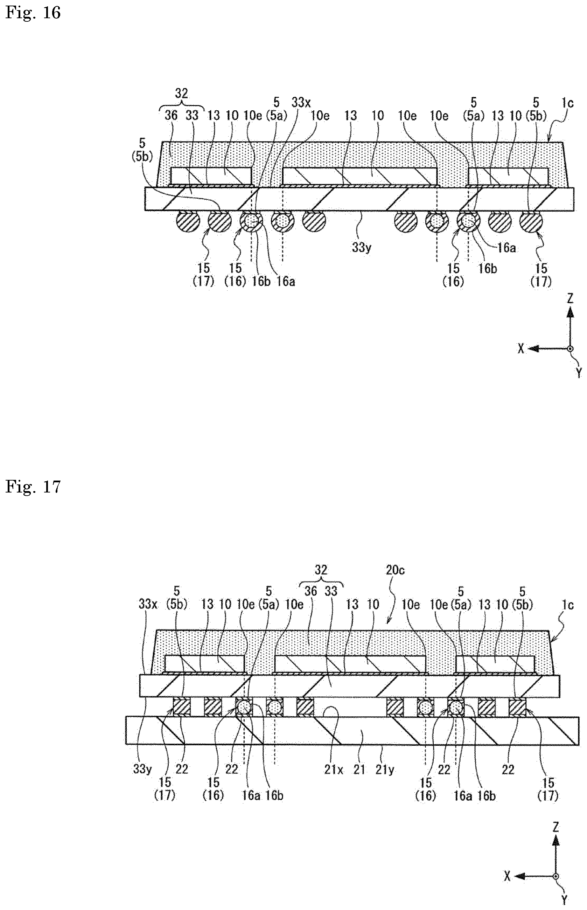

   Fig. 16 is a cross-sectional view schematically showing a configuration example of a semiconductor device according to a third embodiment of the present technology.
[Fig. 17]
   Fig. 17 is a plan view schematically showing a configuration example of an electronic device according to the third embodiment of the present technology.
[Fig. 18]

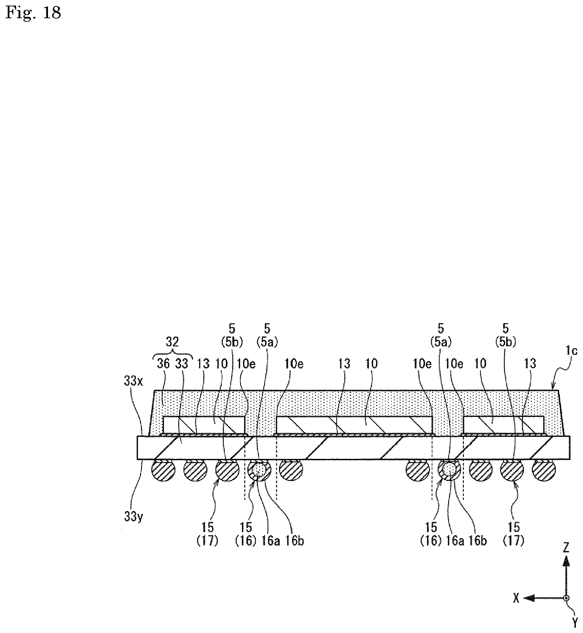

   Fig. 18 is a bottom view schematically showing a modification of the semiconductor device according to the third embodiment of the present technology.

### [Description of Embodiments]

Embodiments of the present technology will be described below with reference to the drawings.

In the descriptions of the drawings referred to in the following description, the same or similar portions will be denoted by same or similar reference signs. However, it should be noted that the drawings are schematic, and the relationships between thicknesses and planar dimensions, ratios of thicknesses of respective layers, and the like are different from actual ones. Therefore, specific thicknesses and dimensions should be determined by considering the following descriptions.

In addition, it goes without saying that the drawings also include portions having dimensional relationships and ratios different from each other. Furthermore, the advantageous effects described in the present specification are merely exemplary and not intended as limiting, and other advantageous effects may be produced.

In addition, the following embodiments exemplify devices and methods for embodying the technical ideas of the present technology, and the configurations are not limited to those described below. That is, the technical ideas of the present technology can be variously modified within the technical scope described in the claims.

In addition, it is to be understood that definitions of directions such as a vertical direction in the following descriptions are merely definitions provided for convenience of explanation and do not limit the technical idea of the present technology. For example, it is obvious that when a target is rotated 90° and observed, the top and bottom will be converted to the left and right and, obviously, if the target is rotated 180° and observed, the top and bottom will be read as reversed.

In the following embodiments, in three directions orthogonal to each other in a space, a first direction and a second direction orthogonal to each other in the same plane are defined as an X direction and a Y direction, respectively, and a third direction orthogonal to each of the first direction and the second direction is defined as a Z direction. In the following embodiments, a thickness direction of a circuit board 3, which will be described later, is defined as the Z direction.

### [First Embodiment]

This first embodiment describes an example of applying the present technology to a BGA-type semiconductor device and an electronic device in which a plurality of solder bumps are arranged on one surface of a ceramic package body.

### «Overall configuration of semiconductor device»

As shown in Figs. 1 to 4, a semiconductor device 1A according to the first embodiment of the present technology includes a package body 2 that includes a semiconductor chip 10 and has a plurality of lands (first lands) 5 arranged on one surface, and a plurality of solder bumps 15 that are individually bonded to the plurality of lands 5 respectively.

### <Package body>

The package body 2 has the circuit board 3 that has a first surface 3x and a second surface 3y that are opposite to each other in the thickness direction (Z direction), and is referred to as an interposer, a frame 6 disposed on the first surface 3x side of this circuit board 3, and a cover plate 7 disposed on the side opposite to this frame 6 from the circuit board 3 side.

On a chip mounting area on the first surface 3x side of the circuit board 3, the semiconductor chip 10 is bonded and fixed by means of an adhesive material 13. For example, solder is used as the adhesive material 13.

### <Circuit board>

As shown in Figs. 1 and 4, the circuit board 3 has a quadrate planar shape in a two-dimensional plane orthogonal to the thickness direction (Z direction), and has, for example, a square shape in this first embodiment. The circuit board 3 has, for example, a multilayer wiring structure in which wiring layers are stacked in a plurality of stages via an insulating layer. The insulating layer is composed of a ceramic plate made of alumina (Al₂O₃), for example. The wiring layer is composed of, for example, a tungsten (W) film as a metal film that can withstand the firing temperature of the insulating layer.

As shown in Fig. 2, the circuit board 3 has electrode pads 4 provided on the first surface 3x side and the lands 5 provided on the second surface 3y side. The lands 5 function as the first lands provided on one surface of the package body 2. The electrode pads 4 are provided on the uppermost wiring layer counting from the second surface 3y side of the circuit board 3. The land 5 is provided in the lowest wiring layer counting from the first surface 3x side of the circuit board 3.

The electrode pads 4 are not shown in detail, but a plurality of the electrode pads 4 are arranged outside the chip mounting area of the circuit board 3 so as to surround this chip mounting area. Although not shown in detail, the lands 5 are repeatedly arranged in the X and Y directions, respectively, which are mutually orthogonal in a two-dimensional plane, in a peripheral area surrounding the central area of the second surface 3y of the circuit board 3. That is, the plurality of lands 5 are arranged in an array manner except for the central area of the second surface 3y of the circuit board 3. Each of the electrode pads 4 and lands 5 is composed of a metal film similar to the wiring layer of the circuit board 3, for example.

### <Frame and cover plate>

As shown in Figs. 1 to 3, the frame 6 has a quadrate planar shape in a two-dimensional plane orthogonal to its thickness direction (Z direction), and has, for example, a square shape similar to the circuit board 3 in this first embodiment. The frame 6 is bonded and fixed to a peripheral area on the first surface 3x side of the circuit board 3 by means of an adhesive material 9a. The frame 6 is composed of a ceramic plate made of alumina (Al₂O₃), for example. The frame 6 has a planar size that is almost the same as the planar outline size of the circuit board 3.

The cover plate 7 has a quadrate planar shape in a two-dimensional plane orthogonal to its thickness direction (Z direction), and has, for example, a square shape similar to the circuit board 3 in this first embodiment. The cover plate 7 is bonded and fixed to the opposite side of the frame 6 from the circuit board 3 side by means of an adhesive material 9b.

The cover plate 7 is made of, for example, transparent glass that transmits light, and has a planar size that is almost the same as the planar outline size of the frame 6. Epoxy resin materials, for example, are used as the adhesive materials 9a and 9b. A cover plate having a transparent glass surface coated with a filter can also be used as the cover plate 7.

### <Semiconductor chip>

As shown in Figs. 1 to 3, the semiconductor chip 10 is bonded and fixed to the chip mounting area on the first surface 3x side of the circuit board 3 by means of the adhesive material 13, and hermetically sealed in a cavity 8 configured by the circuit board 3, the frame 6, and the cover plate 7. The cavity 8 is filled with air or inert gas, for example.

The semiconductor chip 10 has a quadrate planar shape in a two-dimensional plane orthogonal to its thickness direction (Z direction), and has, for example, a square shape in this first embodiment. The semiconductor chip 10 has a main surface and a back surface located on sides opposite to each other, and is bonded and fixed to the first surface 3x of the circuit board 3, with the adhesive material 13 interposed between the back surface and the first surface 3x of the circuit board 3.

As shown in Fig. 2, bonding pads 11 are provided on the main surface of the semiconductor chip 10. Although not shown in detail, the bonding pads 11 are arranged in plurality along each of the four sides of the two-dimensional plane of the semiconductor chip 10, for example.

As shown in Fig. 2, the plurality of bonding pads 11 are individually connected to the plurality of electrode pads 4 of the circuit board 3, respectively, by means of, for example, bonding wires 14 as connecting members. The bonding wires 14 have one ends connected to the bonding pads 11 of the semiconductor chip 10 and the other ends connected to the electrode pads 4 of the circuit board 3. For example, gold (Au) wires are used as the bonding wires 14. The bonding wires 14 are connected using, for example, a ball bonding (nail head bonding) method that combines thermal compression bonding with ultrasonic vibration.

A solid-state imaging device (image sensor), for example, is mounted on the semiconductor chip 10 as a light detection device. The solid-state imaging device has a pixel array portion provided on the main surface side of the semiconductor chip 10. In this pixel array portion, a plurality of pixels are arranged in an array. Each of the plurality of pixels includes a photoelectric conversion unit (photoelectric conversion element) that photoelectrically converts light incident from the main surface of the semiconductor chip 10 through the cover plate 7, into a signal charge.

### <Solder bumps>

As shown in Figs. 2 to 4, each of the plurality of solder bumps 15 is repeatedly arranged in each of the directions, the X and Y directions, which are mutually orthogonal in a two-dimensional plane, in the peripheral area surrounding the central area of the second surface 3y of the circuit board 3. That is, the plurality of solder bumps 15 are arranged in an array except for the central area of the second surface 3y of the circuit board 3.

The plurality of solder bumps 15 constitute one bump group on one surface of the package body 2. The plurality of solder bumps 15, that is, a solder bump group including the plurality of solder bumps 15 includes core solder bumps 16 including cores 16a and coreless solder bumps 17 without cores.

The core solder bump 16 includes, for example, a spherical-shaped resinous core 16a and a solder layer 16b that encapsulates this core 16a. For example, solder with a Sn (tin)-Ag (silver)-Cu (copper) composition (SAC composition) is used as the solder layer 16b. For example, a coreless solder bump with a Sn-Ag-Cu composition similar to the solder layer 16b of the core solder bump 16 is used as the coreless solder bump 17.

Here, as shown in Fig. 7, the semiconductor device 1A is mounted on a first surface 21x side of a mounting substrate 21 in the manufacturing process of the electronic device 20A described below. Mounting of the semiconductor device 1A is performed by melting the solder bumps 15 located on one surface of the package body 2 by heat treatment (reflow) and then hardening it by cooling, to bond (adhere) the solder bumps 15 to lands 22 functioning as the second lands of the mounting substrate 21. In this step of mounting the semiconductor device 1A, stress caused by the difference in thermal expansion coefficient between the package body 2 and the mounting substrate 21 is added to the solder bumps 15 during the cooling process performed after the heat treatment. Therefore, it is preferred that the core solder bumps 16 be arranged at sections where the stress caused by the difference in thermal expansion coefficient between the package body 2 and the mounting substrate 21 is concentrated, during the cooling process performed after melting the plurality of solder bumps 15 including the core solder bumps 16 and the coreless solder bumps 17. In this first embodiment, although not limited thereto, the core solder bumps 16 are arranged at, for example, each of four corners 3c on the second surface 3x side of the circuit board 3, that is, at each of the four corners 3c on one surface side of the package body 2, as shown in Fig. 3 and 4. In this first embodiment, three are arranged per corner 3c, although not limited thereto.

As shown in Fig. 3, the core solder bumps 16 are electrically and mechanically bonded (adhered) to lands 5a arranged in the corners 3c on one surface side of the package body 2. Also, as shown in Figs. 2 and 3, the coreless solder bumps 17 are electrically and mechanically bonded (adhered) to other lands 5b, which are different from the lands 5a on the corners 3c on one surface side of the package body 2.

As shown in Figs. 2 and 3, the external shape of the core solder bumps 16 is a spherical shape (ball shape). Similarly, the external shape of the coreless solder bumps 17 is also a spherical shape (ball-shaped).

Although not provided in this first embodiment, a metallization layer may be provided on surfaces of the lands 5 for the purpose of enhancing bondability with the solder of the solder bumps 15. In this case, the lands 5 may be defined as a configuration including the metallization layer.

### «Method of manufacturing semiconductor device»

Next, a method of manufacturing the semiconductor device 1A according to this first embodiment will be described with reference to Fig. 5A to Fig. 5D.

First, the package body 2 shown in Fig. 5Ais formed. The package body 2 includes the circuit board 3, the frame 6, the cover plate 7, and the cavity 8 configured with the circuit board 3, the frame 6, and the cover plate 7. The package body 2 hermetically seals the semiconductor chip 10 in the cavity 8. Also, the package body 2 has the plurality of lands (first lands) 5 arranged on one surface corresponding to the second surface 3y of the circuit board 3.

Next, although not shown, a paste-like flux layer is formed on each of the lands 5 of the package body 2, for example, by a screen printing method using a metal mask.

Next, as shown in Fig. 5B, coreless solder balls 17Ba having an Sn-Ag-Cu composition are supplied on each of the lands 5 of the package body 2. The coreless solder balls 17Ba are supplied by, for example, arranging a metal mask 18 as an alignment jig on one surface side of the package body 2 and swinging the coreless solder balls 17Ba into through-holes of the metal mask 18. The coreless solder balls 17Ba melt and harden into the coreless solder bumps 17 shown in Figs. 2 to 4. The coreless solder balls 17Ba are composed of solder having the same composition as the coreless solder bumps 17.

In this step, as shown in Fig. 5B, the alignment jig 18 is not provided with through-holes in parts of the plurality of lands 5 that overlap the lands 5a where the core solder bumps 16 (see Figs. 2 to 4) are formed, and therefore the coreless solder balls 17Ba are not supplied to the lands 5a where the core solder bumps 16 are formed. In this first embodiment, the coreless solder balls 17Ba are not supplied to the lands 5a located at the corners 3c (corners 3c on the second surface 2y side of the circuit board 3) on one surface side of the package body 2. That is, the coreless solder balls 17Ba are selectively supplied to the lands 5b where the coreless solder bumps 17 (see Figs. 2 to 4) are formed, the lands 5b being among the plurality of lands 5 arranged on the one surface side of the package body 2.

Next, after eliminating (removing) the alignment jig 18, as shown in Fig. 5C, core solder balls 16Ba provided with the cores 16a in the solder layers 16b are supplied on the lands 5a where the core solder bumps 16 are formed, by using, for example, a suction jig 19. The core solder balls 16Ba melt and harden into the core solder bumps 16 shown in Figs. 2 to 4.

Next, the semiconductor device lAin which the core solder balls 16Ba and the coreless solder balls 17Ba are arranged is transported to, for example, an infrared reflow oven, and then subjected to heat treatment (reflow) as shown in Fig. 5D to melt the solder layers 16b of the core solder balls 16Ba and the coreless solder balls 17Ba, which are then hardened.

In this step, the core solder bumps 16 that include the cores 16a and the solder layers 16b of the core solder balls 16Ba and are adhered to lands 5a, are formed, and the coreless solder bumps 17 that include the solder of the coreless solder balls 17Ba and are adhered to the lands 5b, are formed. The plurality of solder bumps 15 including the core solder bumps 16 and the coreless solder bumps 17 are formed on one surface side of the package body 2, and the solder bump group including the plurality of solder bumps 15 is formed. Each of the core solder bumps 16 and coreless solder bumps 17 is formed in a spherical shape in appearance that is bonded to each land 5.

Thereafter, the semiconductor device 1A shown in Figs. 1 to 4 is almost completed by applying a cleaning step, an inspection step, and the like.

The flux layer on the lands 5 may be formed all at once by a transfer method using a pin transfer member.

The coreless solder balls 17Ba may be supplied onto the lands 5b at once by using a suction block capable of suctioning the plurality of coreless solder balls 17Ba.

The core solder balls 16Ba may be supplied onto the lands 5a at once by using a suction block capable of suctioning the plurality of core solder balls 16Ba.

### «Overall configuration of electronic device»

Next, the electronic device 20A of this first embodiment will be described using Figs. 6 and 7.

As shown in Figs. 6 and 7, the electronic device 20A according to this first embodiment of the present technology includes the mounting substrate 21 having the first surface 21x and the second surface 21y located sides opposite to each other in the thickness direction, and the semiconductor device 1A mounted on the first surface 21x side of this mounting substrate 21.

The mounting substrate 21 has, for example, a multilayer wiring structure in which wiring layers are stacked in multiple stages via an insulating layer. The insulating layer is composed of, for example, a resin substrate made of, for example, glass fiber impregnated with epoxy or polyimide resin. The wiring layers consist of, for example, a metal film having Cu as its main component. That is, the mounting substrate 21 of this first embodiment is composed of a printed circuit board. The mounting substrate 21 composed of the printed circuit board has a thermal expansion coefficient different from that of the package body 2 made of ceramic.

The mounting substrate 21 has the lands 22 provided on the first surface 21x side. The lands 22 function as the second lands. The plurality of lands 22 are arranged so as to correspond to the plurality of solder bumps 15 of the semiconductor device 1A. That is, the arrangement pattern of the plurality of lands 22 is the same as the arrangement pattern of the plurality of solder bumps 15 including the core solder bumps 16 and the coreless solder bumps 17. The lands 22 are provided in the uppermost wiring layer counting from the second surface 21y side of the mounting substrate 21.

The core solder bumps 16 included in the plurality of solder bumps 15 (solder bump group) are interposed between the lands 5a on the corners 3c of the package body 2 of the semiconductor device 1A and the lands 22 on the first surface 21x side of the mounting substrate 21, and are electrically and mechanically bonded (adhered) to these respective lands 5a and lands 22. The coreless solder bumps 17 included in the plurality of solder bumps 15 (solder bump group) are interposed between the other lands 5b different from the lands 5a of the corners 3c of the package body 2 of the semiconductor device 1A and the lands 22 on the first surface 21x side of the mounting substrate 21, and are electrically and mechanically bonded (adhered) to these respective lands 5 and lands 22.

That is, the electronic device 20A of this first embodiment includes the semiconductor device lAin which the plurality of lands (first lands) 5 are arranged on one surface of the package body 2 including the semiconductor chip 10, and the mounting substrate 21 in which the plurality of lands (second lands) 22 are arranged on one surface. The electronic device 20A of this first embodiment also includes the plurality of solder bumps 15 that are individually interposed between the plurality of respective lands 5 on the semiconductor device 1A side and the plurality of respective lands 22 on the mounting substrate 21 side and that individually bond the plurality of lands 5 on the semiconductor device 1A side and the plurality of lands 22 on the mounting substrate 21 side. The plurality of solder bumps 15 include the core solder bumps 16 including the cores 16a and the coreless solder bumps 17 without cores. In the step of mounting the semiconductor device 1A during the manufacturing process for the electronic device 20A, the core solder bumps 16 are arranged at the corners 3c on one surface side of the package body 2 as the sections where stress caused by the difference in thermal expansion coefficient between the package body 2 and the mounting substrate 21 is concentrated, in the cooling process that is performed after each of the plurality of solder bumps 15 including the core solder bumps 16 and the coreless solder bumps 17 are melted and individually bonded to each of the plurality of lands 22.

As shown in Fig. 7, the external shape of each of the core solder bumps 16 and coreless solder bumps 17 is, for example, a cylindrical shape. That is, the external shape of each of the core solder bumps 16 and coreless solder bumps 17 varies before and after the semiconductor device 1A is mounted on the mounting substrate. Before the semiconductor device 1A is mounted on the mounting substrate, the external shape of each of the core solder bumps 16 and coreless solder bumps 17 is a spherical shape.

In addition to the semiconductor device 1A, passive components such as resistors and capacitors are mounted on the mounting substrate 21 as discrete components, but only the semiconductor device 1A is shown in Figs. 6 and 7.

The electronic device 20A of this first embodiment is incorporated in electronic equipment such as a surveillance camera, a video camera, a cellular phone, and a smartphone.

### «Method of mounting semiconductor device»

Next, a method of mounting the semiconductor device 1A will be described using Figs. 8A through 8C, the method being included in the manufacturing process for the electronic device 20A.

First, as shown in Fig. 8A, paste-like pre-solder layers 23 are formed on the plurality of lands 22 arranged on the first surface 21x side of the mounting substrate 21. The solder layers 23 can be formed by, for example, a screen printing method. For example, solder with the same Sn-Ag-Cu composition as the solder of the solder bumps 15 (the solder layers 16b of the core solder bumps 16 and the solder of the coreless solder bumps 17) can be used as the pre-solder layers 23.

Next, as shown in Fig. 8B, the semiconductor device 1A is disposed on the first surface 21x side of the mounting substrate 21 so that the solder bumps 15 of the semiconductor device 1A are positioned on the lands 22 on the first surface 21x side of the mounting substrate 21 via the pre-solder layers 23.

Next, as shown in Fig. 8C, the mounting substrate 21 on which the semiconductor device 1A is disposed is transported to, for example, an infrared reflow oven, is then subjected to heat treatment (reflow) to melt the solder layers 16b of the core solder bumps 16, the coreless solder bumps 17, and the pre-solder layers 23, and is then cooled and hardened.

This step forms the core solder bumps 16 which are bonded to the respective (both of) lands 5a of the corners 3c of the package body 2 of the semiconductor device 1A and lands 22 of the mounting substrate 21, and which incorporate the solder of the pre-solder layers 23. There also are formed the coreless solder bumps 17 which are bonded to the respective (both of) other lands 5b different from lands 5a of the corners 3c of the package body 2 of the semiconductor device 1A and lands 22 of the mounting substrate 21, and which incorporate the solder of the pre-solder layers 23. The external shape of each of the core solder bumps 16 and coreless solder bumps 17 changes from the spherical shape shown in Fig. 3 to, for example, a cylindrical shape shown in Fig. 8C.

By this step, the semiconductor device 1A is mounted on the first surface 21x side of the mounting substrate 21, with the plurality of solder bumps 15 with the core solder bumps 16 and coreless solder bumps 17 therebetween.

### «Main effects of first embodiment»

Next, the main effects of this first embodiment will be described with reference to Fig. 9. Fig. 9 is a cross-sectional view schematically showing a state in which the mounting substrate is warped.

As described above, the semiconductor device 1A according to this first embodiment has the plurality of solder bumps 15 (solder bump group) including the core solder bumps 16 and the coreless solder bumps 17. The semiconductor device 1A is mounted on the mounting substrate 21 in the mounting step during the manufacturing process of the electronic device 20A. The semiconductor device 1A is mounted by melting the plurality of solder bumps 15 by heat treatment, and then hardening them by cooling, to individually bond the plurality of solder bumps 15 to the plurality of lands 22 on the mounting substrate 21. In this step of mounting the semiconductor device 1A, stress caused by the difference in thermal expansion coefficient between the package body 2 and the mounting substrate 21 is added to the solder bumps 15 during the cooling process performed after the heat treatment. In the semiconductor device 1A according to this first embodiment, as the sections where stress caused by the difference in thermal expansion coefficient between the package body 2 and the mounting substrate 21 is concentrated, the core solder bumps 16 are arranged at the corners 3c on one surface side of the package body 2 where the stress is most concentrated, in the cooling process performed after the heat treatment. By including the cores 16a in the core solder bumps 16, the stress added due to the difference in thermal expansion coefficient between the package body 2 and the mounting substrate 21 can be reduced, and the stress at the bonding interface with the lands 5a on the package body 2 side and the lands 22 on the mounting substrate 21 side can be reduced. Therefore, according to the semiconductor device 1A of this first embodiment, mounting reliability can be improved.

On the other hand, the mounting substrate 21 is not necessarily flat, and as an example shown in Fig. 9, the mounting substrate 21 may be warped in a direction where the first surface 21x side of the mounting substrate 21 is convex. In the semiconductor device 1A of this first embodiment, the coreless solder bumps 17 are arranged at sections other than the core solder bumps 16. Unlike the core solder bumps 16, the coreless solder bumps 17 do not contain cores, and therefore have better followability against the warpage of the mounting substrate 21 compared to the core solder bumps 16. The followability to the warpage of the mounting substrate 21 means that the distance between the lands 5 on the package body 2 side and the lands 22 on the mounting substrate 21 side changes according to the degree of warpage of the mounting substrate 21, and that the shape of the solder bumps flexibly changes according to this change in distance. In the core solder bumps 16, when the distance between the lands 5 and the lands 22 becomes narrower, the sinking becomes restricted by the cores 16a, and when the distance between the lands 5 and the lands 22 becomes wider, the amount of solder in the solder layers 16b becomes less, resulting in a smaller stretch and lower followability compared to the coreless solder bumps 17. In contrast, in the coreless solder bumps 17, when the distance between the lands 5 and the lands 22 becomes narrower, sinking occurs flexibly due to the absence of cores, and when the distance between the lands 5 and the lands 22 becomes wider, the amount of solder becomes greater, resulting in greater stretch and higher followability compared to the core solder bumps 16. Fig. 9 illustrates the case where the mounting substrate 21 is warped in the direction where the first surface 21x side of the mounting substrate 21 is convex, but the coreless solder bumps 17 have better followability than the core solder bumps 16 even when the mounting substrate 21 is warped in the direction where the first surface 21x side of the mounting substrate 21 is concave. Therefore, by arranging the core solder bumps 16 at the corners 3c on one surface side of the package body 2 as the sections where the stress caused by the difference in thermal expansion coefficient between the package body 2 and the mounting substrate 21 is most concentrated during the cooling process after the heat treatment, and by arranging the coreless solder bumps 17 at other sections, the mounting reliability of the semiconductor device 1A can be further improved.

In addition, by mixing core solder bumps 16 and the coreless solder bumps 17, the inclination of the semiconductor device 1A with respect to the mounting substrate 21 can be suppressed, thereby suppressing the effect of image quality degradation.

Specifically, when assuming all the solder bumps 15 are the coreless solder bumps 17, as in the prior art shown in Fig. 10A, a semiconductor device 1Z may tilt due to warping of the mounting substrate 21 or the semiconductor device 1Z when the semiconductor device 1Z is mounted. When such tilting occurs, a final lens (imaging lens) 42, which is supported by the mounting substrate 21 via a support 41 and which guides incident light to the pixel array portion of the semiconductor chip 10 of the semiconductor device 1Z, and the semiconductor device 1Z are no longer parallel by design values, causing the image capture quality to deteriorate.

In contrast, as shown in Fig. 10B, the semiconductor device 1A of this first embodiment is not affected by the warpage of the mounting substrate 21 or the semiconductor device 1A because the core solder bumps 16 are arranged in the corners 3c of the circuit board 3, and the tilting that occurs after mounting the semiconductor device 1A on the mounting substrate 21 can be improved.

Although not shown in the drawings, the mounting reliability of the semiconductor device 1A can be further improved even when the package body 2 has warpage where the second surface side is convex or concave.

### «Relation between external shape of coreless solder bumps and distortion»

Next, the relationship between the external shape of the coreless solder bumps 17 and distortion (stress) is explained using Fig. 11. Fig. 11 is a diagram showing the results of simulation of the relationship between the external shape and distortion (stress) of the coreless solder bumps 17. In Fig. 11, the horizontal axis indicates the ratio of a width dimension b of the center of the coreless solder bumps 17 in the height direction to a width dimension a of an edge (center dimension b/edge dimension a), and the horizontal axis indicates a plastic distortion (stress) rate. Data B represents the distortion generated in the middle portion of a coreless solder bump 17 in the height direction (the portion with the width dimension b), and data A represents the distortion generated in the bonding interface portion between the coreless solder bump 17 and the land 5 arranged in the corner 3c on one surface side of the package body 2 (the portion with the width dimension a). Both the data B and the data A are simulation data obtained in the state where the coreless solder bump 17 is melted and hardened to bond (adhere) to both the land 5 on the package body 2 side and the land 22 on the mounting substrate 21 side. The diameter of both lands is, for example, 0.4 mm.

As shown by the data B, the distortion on the middle portion of the coreless solder bump 17 (the portion with the width dimension b) decreased from the ratio of 0.5 to the ratio of 1, and was almost zero at the ratio of 1. On the other hand, as shown by the data A, the distortion on the edge of the coreless solder bump 17 (the portion with the width dimension a) tended to increase gradually from the ratio of 0.5 to the ratio of 1.5. Here, the external shape of the coreless solder bump 17 is cylindrical at the ratio of 1, the shape of the middle portion (the portion with the dimension b) is narrower than that of the edge (the portion with the dimension a) at a ratio of less than 1 (hand drum shape), and the middle portion (the portion with the dimension b) is thicker than the edge (the portion with the dimension a) when the ratio exceeds 1 (drum shape).

It was understood from Fig. 11 that the coreless solder bump 17 had a stress dispersion effect due to the change in external shape. It was also understood that the ratio of 0.82 (20% narrower) was optimal for the stress dispersion effect. Therefore, it was understood that the change in the external shape of the coreless solder bump 17 also increased the service life thereof due to the stress dispersion effect. The improvement in the mounting reliability of the semiconductor device 1A can be further achieved by mixing the core solder bumps 16 and the coreless solder bumps 17.

### «Modifications of first embodiment»

The first embodiment above has described the case in which the core solder bumps 16 are arranged in the corners 3c on one surface side of the package body 2 as the sections where the stress caused by the difference in thermal expansion coefficient between the package body 2 and the mounting substrate 21 are most concentrated during the cooling process performed after the heat treatment. However, the present technology is not limited to arranging the core solder bumps 16 as in the first embodiment described above. For example, as shown in Fig. 12, the core solder bumps 16 may be arranged in a row on the outer periphery. In this case as well, the same effects as in the first embodiment described above can be obtained.

In Fig. 12, the core solder bumps 16 are arranged in a row on the outer periphery in a continuous manner, but the core solder bumps 16 may be scattered in a row on the outer periphery.

### [Second Embodiment]

As shown in Figs. 13 and 14, a semiconductor device 1B according to the second embodiment of the present technology has basically the same configuration as the semiconductor device 1A according to the first embodiment described above, but the arrangement of the core solder bumps 16 in the plurality of solder bumps 15 is different.

That is, as shown in Figs. 13 and 14, the core solder bumps 16 are arranged in a location superimposed on a contour (perimeter, edge) 10e of the semiconductor chip 10 in plan view. In this second embodiment, although not limited thereto, the core solder bumps 16 are arranged in plurality along each of the four sides of the semiconductor chip 10 in plan view. The other configurations are the same as those described in the first embodiment above. In Fig. 14, the core solder bumps 16 are arranged continuously with respect to each side of the semiconductor chip 10, but the core solder bumps 16 may be scattered with respect to each side of the semiconductor chip 10.

As shown in Fig. 15, in an electronic device 20B in which the semiconductor device 1B is mounted on the mounting substrate 21, the core solder bumps 16 are arranged in a location superimposed on the contour 10e of the semiconductor chip 10 in plan view. In this second embodiment as well, the external shape of each of the core solder bumps 16 and the coreless solder bumps 17 changes from the spherical shape shown in Fig. 13 to, for example, the cylindrical shape shown in Fig. 15.

Fig. 13 schematically shows a cross-sectional structure at the same location as line III-III shown in Fig. 1, and Fig. 15 schematically shows a cross-sectional structure at the same location as line IV-IV shown in Fig. 6.

In mounting the semiconductor device 1B according to this second embodiment as well, as in the mounting of the semiconductor device 1A according to the first embodiment described above, by melting the plurality of solder bumps 15 by heat treatment and then hardening them by cooling, the plurality of solder bumps 15 are individually bonded to the plurality of lands 22 on the mounting substrate 21. In this step of mounting the semiconductor device 1B, the semiconductor chip 10 is adhered to the first surface 3x side of the circuit board 3 via the adhesive material 13. Therefore, stress is concentrated on the solder bumps 15 at the section superimposed on the contour 10e of the semiconductor chip 10 in plan view, as the section where stress is concentrated due to the difference in thermal expansion coefficient between the package body 2 and the mounting substrate 20 during the cooling process performed after the heat treatment. However, in this second embodiment, the core solder bumps 16 are arranged in the section superimposed on the contour 10e of the semiconductor chip 10 in plan view, and the coreless solder bumps 17 are arranged at other sections. Therefore, in the semiconductor device 1B according to this second embodiment as well, as with the semiconductor device 1A of the first embodiment described above, mounting reliability can be further improved.

The arrangement of the core solder bumps 16 of this second embodiment (see Figs. 13 and 14) may be combined with the arrangement of the core solder bumps 16 of the first embodiment described above (Figs. 3 and 4). That is, the core solder bumps 16 may be arranged at the corners 3c on one surface side of the package body 2, and the core solder bumps 16 may be arranged in the section superimposed on the contour 10e of the semiconductor chip 10 in plan view.

The arrangement of the core solder bumps 16 of this second embodiment (see Figs. 13 and 14) may be combined with the arrangement of the core solder bumps 16 shown in the modification of the first embodiment described above (see Fig. 12). That is, the core solder bumps 16 may be arranged in a row on the outer periphery of the plurality of solder bumps 15, and the core solder bumps 16 may also be arranged in a section superimposed on the contour 10e of the semiconductor chip 10 in plan view.

The first and second embodiments above have described the semiconductor devices 1A and 1B including the package body 2 in which the frame 6 is fixed to the circuit board 3, but the present technology is also applicable to a semiconductor device that includes a circuit board (base member) in which a chip mounting area is provided in a recess surrounded by a frame portion, that is, a circuit board in which a frame portion and a base portion are fired together.

The present technology can also be applied to a semiconductor device including a resinous circuit board instead of a ceramic circuit board, and to an electronic device equipped with such semiconductor device.

The present technology can also be applied to a semiconductor device in which a semiconductor chip is mounted face-down on a circuit board, and an electronic device equipped with such semiconductor device.

### [Third Embodiment]

This embodiment describes an example of the application of the present invention to a BGA-type semiconductor device 1C having a multi-chip structure, and an electronic device 20C equipped with the semiconductor device 1C.

As shown in Fig. 16, the semiconductor device 1C according to a third embodiment of the present technology has a package body 32 including a plurality of semiconductor chips 10 and having a plurality of lands 5 arranged on one surface, and a plurality of solder bumps 15 individually bonded to the plurality of lands 5 respectively.

The package body 32 has a circuit board 33 having a first surface 33x and a second surface 33y opposing each other in the thickness direction (Z direction), and a resin sealant 36 provided on the first surface 33x side of the circuit board 33. On the first surface 33x side of the circuit board 33, the plurality of semiconductor chips 10 are bonded and fixed via an adhesive material 13. In Fig. 16, although not limited thereto, three semiconductor chips 10 are illustrated.

The circuit board 33 has, for example, a multilayer wiring structure in which wiring layers are stacked in a plurality of stages via an insulating layer. This circuit board 33 is composed of a printed circuit board, for example, similar to the mounting substrate 21 shown in Fig. 7 of the first embodiment described above.

Although not shown, the circuit board 33 has electrode pads provided on the first surface 33x side. The circuit board 33 also has the lands 5 provided on the second surface 33y side. The lands 5 of this third embodiment are also arranged in an array, for example, except for the central area of the second surface 3y of the circuit board 3. The lands 5 of this third embodiment also function as the first lands provided on one surface side of the package body 32.

The resin sealant 36 seals the plurality of semiconductor chips 10 arranged on the first surface 33x side of the circuit board 33. The resin sealant 36 is composed of, for example, an epoxy thermosetting resin. The resin sealant 36 is formed using, for example, a transfer molding method suitable for mass production.

As shown in Fig. 16, each of the plurality of semiconductor chips 10 has a main surface and a back surface located to oppose each other and is bonded and fixed to the first surface 33x of the circuit board 33, with the adhesive material 13 interposed between the back surface and the first surface 33x of the circuit board 33. Each of the plurality of semiconductor chips 10 is sealed in the package body 32 including the circuit board 33 and the resin sealant 36.

On the main surface of each of the plurality of semiconductor chips 10, bonding pads are provided, although not shown. Each of the bonding pads of the plurality of semiconductor chips 10 is electrically connected to an electrode pad on the first surface 33x side of the circuit board 33 via, for example, a bonding wire such as a connecting member. Each of the plurality of semiconductor chips 10 is equipped with an integrated circuit, such as a control circuit, a memory circuit, a logic circuit, or a photoelectric conversion circuit.

Each of the plurality of solder bumps 15 is repeatedly arranged in each of the directions, the X and Y directions, which are mutually orthogonal in a two-dimensional plane, in a peripheral area surrounding the central area of the second surface 33y of the circuit board 3. That is, the plurality of solder bumps 15 are arranged in an array manner except for the central area of the second surface 33y of the circuit board 33, as in the first embodiment described above.

The plurality of solder bumps 15 constitute one bump group on one surface of the package body 32, as in the first embodiment described above. The plurality of solder bumps 15, that is, a solder bump group including the plurality of solder bumps 15 includes core solder bumps 16 including cores 16a and coreless solder bumps 17 without cores.

As shown in Fig. 16, the core solder bumps 16 are arranged in locations superimposed on contours (perimeters, edges) 10e of the semiconductor chips 10 in plan view. As shown in Fig. 17, in the electronic device 20C in which the semiconductor device 1C is mounted on the mounting substrate 21, the core solder bumps 16 are arranged in the locations superimposed on the contours 10e of the semiconductor chips 10 in plan view. In this third embodiment as well, the external shape of each of the core solder bumps 16 and coreless solder bumps 17 changes from the spherical shape shown in Fig. 16 to, for example, a cylindrical shape shown in Fig. 17.

As shown in Fig. 17, the electronic device 20C of this third embodiment includes the semiconductor device 1C in which the plurality of lands (first lands) 5 are arranged on one surface of the package body 32 including the plurality of semiconductor chips 10, and the mounting substrate 21 in which a plurality of lands (second lands) 22 are arranged on one surface. The electronic device 20C of this third embodiment also includes the plurality of solder bumps 15 that are individually interposed between each of the plurality of lands 5 on the semiconductor device 1C side and each of the plurality of lands 22 on the mounting substrate 21 side, and that individually bond the plurality of lands 5 on the semiconductor device 1C side and the plurality of lands 22 on the mounting substrate 21 side. The plurality of solder bumps 15 include the core solder bumps 16 including the cores 16a and the coreless solder bumps 17 without cores.

In mounting the semiconductor device 1C in this third embodiment as well, as in the mounting of the semiconductor device 1A according to the first embodiment described above, by melting the plurality of solder bumps 15 by heat treatment and then hardening them by cooling, the plurality of solder bumps 15 are individually bonded to the plurality of lands 22 on the mounting substrate 21. In this step of mounting the semiconductor device 1C, the plurality of semiconductor chips 10 are adhered to the first surface 33x side of the circuit board 33 via the adhesive material 13. Therefore, stress is concentrated on the solder bumps 15 at the locations superimposed on the contours 10e of the semiconductor chips 10 in plan view, as the section where stress is concentrated due to the difference in thermal expansion coefficient between the package body 2 and the mounting substrate 20 during the cooling process performed after the heat treatment. In particular, distortion is easy to occur where the semiconductor chips 10 are adjacent to each other, and stress is concentrated on the solder bumps 15. However, in this third embodiment, the core solder bumps 16 are arranged in the sections superimposed on the contours 10e of the semiconductor chips 10 in plan view, and the coreless solder bumps 17 are arranged in other sections. Therefore, in the semiconductor device 1C according to this third embodiment as well, as in the semiconductor device 1A of the first embodiment described above, mounting reliability can be further improved.

In this third embodiment, the core solder bumps 16 are arranged with respect to each of the two semiconductor chips 10 adjacent to each other, but the core solder bumps 16 may be arranged with respect to any one of the two semiconductor chips 10 adjacent to each other.

The arrangement of the core solder bumps 16 of this third embodiment (see Fig. 16) may be combined with the arrangement of the core solder bumps 16 of the first embodiment described above (Figs. 3 and 4). That is, the core solder bumps 16 may be arranged at the corners on one surface side of the package body 32, and the core solder bumps 16 may be arranged in the sections superimposed on the contours 10e of the semiconductor chips 10 in plan view.

The arrangement of the core solder bumps 16 of this third embodiment (see Fig. 16) may be combined with the arrangement of the core solder bumps 16 shown in the modification of the first embodiment described above (see Fig. 12). That is, the core solder bumps 16 may be arranged in a row on the outer periphery of the plurality of solder bumps 15, and the core solder bumps 16 may also be arranged in the sections superimposed on the contours 10e of the semiconductor chips 10 adjacent to each other in plan view.

### «Modification of third embodiment»

The third embodiment above has described the case in which the core solder bumps 16 are arranged in the sections superimposed on the contours 10e of the semiconductor chips 10 in plan view, as the sections where stress caused by the difference in thermal expansion coefficient between the package body 32 and the mounting substrate 21 is most concentrated during the cooling process performed after the heat treatment. However, the present technology is not limited to the arrangement of the core solder bumps 16 of the third embodiment described above. For example, as shown in Fig. 18, the core solder bumps 16 may be arranged in a section between the semiconductor chips 10 adjacent to each other in plan view. In this case as well, the same effects as in the third embodiment described above can be obtained.

The arrangement of the core solder bumps 16 shown in the modification of the third embodiment (see Fig. 18) may be combined with the arrangement of the core solder bumps 16 shown in the first embodiment described above. That is, the core solder bumps 16 may be arranged in a section between the semiconductor chips 10 adjacent to each other in plan view, and the core solder bumps 16 may be arranged at the corners on one surface side of the package body 32.

The arrangement of the core solder bumps 16 shown in the modification of the third embodiment (see Fig. 18) may be combined with the arrangement of core solder bumps 16 shown in the modification of the first embodiment described above. That is, the core solder bumps 16 may be arranged in a section between semiconductor chips 10 adjacent to each other in plan view, and the core solder bumps 16 may be arranged in a row on the outer periphery of the plurality of solder bumps 15.

Although the above-described embodiments have explained a semiconductor device provided with a package body including a circuit board, the present technology can also be applied to a semiconductor device provided with a package body that does not include a circuit board. In short, the present technology can be applied to all semiconductor devices having a package body that includes a semiconductor chip and has a plurality of lands arranged on one surface side.

Here, the present technology may have the following configurations.
(1) A semiconductor device, including:
   a package body including a semiconductor chip and having a plurality of first lands arranged on one surface; and
   a plurality of solder bumps that are individually bonded to the plurality of lands, respectively,
   wherein
   the plurality of solder bumps include core solder bumps including cores and coreless solder bumps without cores.
(2) The semiconductor device according to (1) described above, wherein the core solder bumps are arranged at sections where stress caused by a difference in thermal expansion coefficient between the package body and a mounting substrate are concentrated during a cooling process performed after each of the plurality of solder bumps including the core solder bumps and the coreless solder bumps is melted and individually bonded to each of a plurality of second lands on the mounting substrate.
(3) The semiconductor device according to (1) or (2) described above, wherein the core solder bumps are arranged at a corner of the package body in plan view.
(4) The semiconductor device according to (1) or (2) described above, wherein the core solder bumps are arranged in a location superimposed on a contour of the semiconductor chip in plan view.
(5) The semiconductor device according to (1) or (2) described above, wherein the core solder bumps are arranged at a corner of the package body and in a location superimposed on a contour of the semiconductor chip in plan view.
(6) The semiconductor device according to (1) or (2) described above, wherein the package body includes a plurality of the semiconductor chips arranged in a two-dimensional plane, and the core solder bumps are arranged between the semiconductor chips adjacent to each other in plan view.
(7) The semiconductor device according to (1) or (2) described above, wherein the package body includes a plurality of the semiconductor chips arranged in a two-dimensional plane, and the core bumps are arranged at a corner of the package body and between the semiconductor chips adjacent to each other in plan view.
(8) The semiconductor device according to any one of (1) to (7) described above, wherein the core solder bumps include the cores and solder layers covering the cores, and the coreless solder bumps are composed of solder.
(9) The semiconductor device according to any one of (1) to (8) described above, wherein the core solder bumps and the coreless solder bumps have an identical external shape.
(10) An electronic device, including:
   a semiconductor device having a plurality of first lands arranged on one surface of a package body including a semiconductor chip;
   a mounting substrate having a plurality of second lands arranged on one surface; and a plurality of solder bumps that are individually interposed between the plurality of first lands and the plurality of second lands, respectively, and are individually bonded to the plurality of first lands and the plurality of second lands, respectively,
   wherein the plurality of solder bumps include core solder bumps including cores and coreless solder bumps without cores.
(11) The electronic device according to (10) described above, wherein the core solder bumps are arranged at sections where stress caused by a difference in thermal expansion coefficient between the package body and the mounting substrate are concentrated during a cooling process performed after each of the plurality of solder bumps including the core solder bumps and the coreless solder bumps is melted and individually bonded to each of the plurality of second lands.
(12) The electronic device according to (10) or (11) described above, wherein the core solder bumps are arranged at a corner of the package body in plan view.
(13) The electronic device according to (10) or (11) described above, wherein the core solder bumps are arranged in a location superimposed on a contour of the semiconductor chip in plan view.
(14) The electronic device according to (10) or (11) described above, wherein the core solder bumps are arranged at a corner of the package body and in a location superimposed on a contour of the semiconductor chip in plan view.
(15) The electronic device according to (10) or (11) described above, wherein the package body includes a plurality of the semiconductor chips arranged in a two-dimensional plane, and the core solder bumps are arranged between the semiconductor chips adjacent to each other in plan view.
(16) The electronic device according to (10) or (11) described above, wherein the package body includes a plurality of the semiconductor chips arranged in a two-dimensional plane, and the core bumps are arranged at a corner of the package body and between the semiconductor chips adjacent to each other in plan view.
(17) The electronic device according to any one of (10) to (16) described above, wherein the core solder bumps include the cores and solder layers covering the cores, and the coreless solder bumps are composed of solder.
(18) The electronic device according to any one of (10) to (17) described above, wherein the core solder bumps and the coreless solder bumps have an identical external shape.

The scope of the present technology is not limited to the illustrated and described exemplary embodiments, but includes all embodiments that provide equivalent effects sought after with the present technology. In addition, the scope of the present technology is not limited to combinations of features of the inventions defined by the claims, but can be defined by any desired combination of specific features among all disclosed features.

### [Reference Signs List]

- 1A, 1B, 1C: Semiconductor device
- 2: Package body
- 3: Circuit board
- 3c: Corner
- 3x: First surface
- 3y: Second surface
- 4: Electrode pad
- 5: Land (first land)
- 6: Frame
- 7: Cover plate
- 8: Cavity
- 9a, 9b: Adhesive material
- 10: Semiconductor chip
- 11: Bonding pad
- 13: Adhesive material
- 14: Bonding wire
- 15: Solder bump
- 16: Core solder bump
- 16a: Core
- 16b: Semiconductor layer
- 16Ba: Core solder ball
- 17: Coreless solder bump
- 17Ba: Coreless solder ball
- 18: Alignment jig
- 19: Suction jig
- 20A, 20B, 20C: Electronic device
- 21: Mounting substrate
- 21x: First surface
- 21y: Second surface
- 22: Land (second land)
- 23: Pre-solder layer
- 32: Package body
- 33: Circuit board
- 33x: First surface
- 33y: Second surface
- 36: Resin sealant
- 41: Support
- 42: Final lens

## Claims

1. A semiconductor device, comprising:
a package body including a semiconductor chip and having a plurality of first lands arranged on one surface; and
a plurality of solder bumps that are individually bonded to the plurality of lands, respectively,
wherein
the plurality of solder bumps include core solder bumps including cores and coreless solder bumps without cores.

2. The semiconductor device according to claim 1, wherein the core solder bumps are arranged at sections where stress caused by a difference in thermal expansion coefficient between the package body and a mounting substrate are concentrated during a cooling process performed after each of the plurality of solder bumps including the core solder bumps and the coreless solder bumps is melted and individually bonded to each of a plurality of second lands on the mounting substrate.

3. The semiconductor device according to claim 1, wherein the core solder bumps are arranged at a corner of the package body in plan view.

4. The semiconductor device according to claim 1, wherein the core solder bumps are arranged in a location superimposed on a contour of the semiconductor chip in plan view.

5. The semiconductor device according to claim 1, wherein the core solder bumps are arranged at a corner of the package body and in a location superimposed on a contour of the semiconductor chip in plan view.

6. The semiconductor device according to claim 1, wherein the package body includes a plurality of the semiconductor chips arranged in a two-dimensional plane, and
the core solder bumps are arranged between the semiconductor chips adjacent to each other in plan view.

7. The semiconductor device according to claim 1, wherein the package body includes a plurality of the semiconductor chips arranged in a two-dimensional plane, and
the core bumps are arranged at a corner of the package body and between the semiconductor chips adjacent to each other in plan view.

8. The semiconductor device according to claim 1, wherein the core solder bumps include the cores and solder layers covering the cores, and
the coreless solder bumps are composed of solder.

9. The semiconductor device according to claim 1, wherein the core solder bumps and the coreless solder bumps have an identical external shape.

10. An electronic device, comprising:
a semiconductor device having a plurality of first lands arranged on one surface of a package body including a semiconductor chip;
a mounting substrate having a plurality of second lands arranged on one surface; and
a plurality of solder bumps that are individually interposed between the plurality of first lands and the plurality of second lands, respectively, and are individually bonded to the plurality of first lands and the plurality of second lands, respectively,
wherein the plurality of solder bumps include core solder bumps including cores and coreless solder bumps without cores.

11. The electronic device according to claim 10, wherein the core solder bumps are arranged at sections where stress caused by a difference in thermal expansion coefficient between the package body and the mounting substrate are concentrated during a cooling process performed after each of the plurality of solder bumps including the core solder bumps and the coreless solder bumps is melted and individually bonded to each of the plurality of second lands.

12. The semiconductor device according to claim 10, wherein the core solder bumps are arranged at a corner of the package body in plan view.

13. The semiconductor device according to claim 10, wherein the core solder bumps are arranged in a location superimposed on a contour of the semiconductor chip in plan view.

14. The semiconductor device according to claim 10, wherein the core solder bumps are arranged at a corner of the package body and in a location superimposed on a contour of the semiconductor chip in plan view.

15. The semiconductor device according to claim 10, wherein the package body includes a plurality of the semiconductor chips arranged in a two-dimensional plane, and
the core solder bumps are arranged between the semiconductor chips adjacent to each other in plan view.

16. The semiconductor device according to claim 10, wherein the package body includes a plurality of the semiconductor chips arranged in a two-dimensional plane, and
the core bumps are arranged at a corner of the package body and between the semiconductor chips adjacent to each other in plan view.

17. The semiconductor device according to claim 10, wherein the core solder bumps include the cores and solder layers covering the cores, and
the coreless solder bumps are composed of solder.

18. The semiconductor device according to claim 10, wherein the core solder bumps and the coreless solder bumps have an identical external shape.
